(19) **Europäisches Patentamt / European Patent Office / Office européen des brevets**

(11) **EP 2 769 313 B1**

(12) **EUROPEAN PATENT SPECIFICATION**

(45) Date of publication and mention
of the grant of the patent:
**17.08.2016 Bulletin 2016/33**

(21) Application number: **12841617.9**

(22) Date of filing: **18.10.2012**

(51) Int Cl.:
*G06F 17/10* (2006.01)          *H03H 17/06* (2006.01)
*H03H 17/02* (2006.01)

(86) International application number:
**PCT/CA2012/050744**

(87) International publication number:
**WO 2013/056375 (25.04.2013 Gazette 2013/17)**

(54) **SYSTEM, METHOD, APPARATUS, AND COMPUTER PROGRAM PRODUCT FOR CALCULATING A SAMPLED SIGNAL**

SYSTEM, VERFAHREN, VORRICHTUNG UND COMPUTERPROGRAMMPRODUKT ZUR BERECHNUNG EINES ABGETASTETEN SIGNALS

SYSTÈME, PROCÉDÉ, APPAREIL ET PRODUIT PROGRAMME D'ORDINATEUR POUR LE CALCUL D'UN SIGNAL ÉCHANTILLONNÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **18.10.2011 US 201161548396 P**

(43) Date of publication of application:
**27.08.2014 Bulletin 2014/35**

(73) Proprietors:
• **Grishin, Alexey**
  **West Vancouver, British Columbia V7W 1A9 (CA)**
• **Zhirkov, Alexander**
  **West Vancouver, British Columbia V7W 1A9 (CA)**
• **Oraevsky, Alexey**
  **West Vancouver, British Columbia V7W 1A9 (CA)**

(72) Inventors:
• **Grishin, Alexey**
  **West Vancouver, British Columbia V7W 1A9 (CA)**
• **Zhirkov, Alexander**
  **West Vancouver, British Columbia V7W 1A9 (CA)**
• **Oraevsky, Alexey**
  **West Vancouver, British Columbia V7W 1A9 (CA)**

(74) Representative: **Hoeger, Stellrecht & Partner Patentanwälte mbB**
**Uhlandstrasse 14c**
**70182 Stuttgart (DE)**

(56) References cited:
**CA-A1- 2 305 381**

• **T. Moeller ET AL: "Evaluation and design of filters using a Taylor series expansion", IEEE Transactions on Visualization and Computer Graphics, vol. 3, no. 2 1 January 1997 (1997-01-01), pages 184-199, XP055199162, DOI: 10.1109/2945.597800 Retrieved from the Internet: URL:http://ieeexplore.ieee.org/xpls/abs_all.jsp?arnumber=597800 [retrieved on 2015-06-30]**
• **VESMA JUSSI ET AL: "Design of polynomial interpolation filters based on Taylor series", 9TH EUROPEAN SIGNAL PROCESSING CONFERENCE (EUSIPCO 1998), IEEE, 8 September 1998 (1998-09-08), pages 1-5, XP032767322, ISBN: 978-960-7620-06-4 [retrieved on 2015-04-20]**
• **MOLLER, T. ET AL.: 'Classification and Local Error Estimation of Interpolation and Derivative Filters for Volume Rendering' PROCEEDINGS OF THE 1996 SYMPOSIUM ON VOLUME VISUALIZATION October 1996, PISCATAWAY. NJ, USA, pages 71 - 78, XP055149728**
• **KRASZEWSKI, G.: 'Non-uniform Kernel Sampling in Audio Signal Resampler' 2005, pages 1 - 5, XP055149730 Retrieved from the Internet: <URL:www.teleiiifo.pb.edu.pl/luashaiVpliki/iloiluiliforiii-saillpliilg 2005.pdf> [retrieved on 2012-12-13]**

**(Cont. next page)**

- **TREFETHEN, L. N.: 'Spectral Methods in Matlab' 17 May 2000, pages 1 - 181, XP055160097 Retrieved from the Internet: <URL:http:/A\wv.mathworks.ii7downloads/Spectral%20Methods%20m%20MATLAB[ www.math w orla. ir].pdf> [retrieved on 2012-12-17]**
- **UNSER, M. ET AL.: 'On the Approximation Power of Convolution-Based Least Squares Versus Interpolation' IEEE TRANSACTIONS ON SIGNAL PROCESSING vol. 45, no. 7, July 1997, pages 1697 - 1711, XP011057860**
- **PARKER, J.A. ET AL.: 'Comparison of interpolating methods for image resampling' IEEE TRANSACTIONS ON MEDICAL IMAGING vol. 2, no. 1, March 1983, pages 31 - 39, XP001189649**

**Description**

BACKGROUND OF THE DISCLOSURE

Field of the Disclosure

Aspects of the present disclosure relate to digital signal processing methods and, more particularly, to a system, method, apparatus, and computer program product for calculating a sampled signal, including calculation of a sampled signal for an arbitrary variation of sampling rate, without the use of polyphase filters.

Description of Related Art

The document T. Moeller ET AL: "Evaluation and design of filters using a Taylor series expansion", IEEE Transactions on Visualization and Computer Graphics, vol. 3, no. 2 1 January 1997 (1997-01-01), pages 184-199, XP055199162,     DOI:     10.1109/2945.597800,     Retrieved     from     the     Internet:     URL:http://ieeexplore.ieee.org/xpls/abs_all.jsp?arnumber=597800 [retrieved on 2015-06-30] describes a method for analyzing, classifying, and evaluating filters that can be applied to interpolation filters as well as to arbitrary derivative filters of any order. The analysis based on the Taylor series expansion of the convolution sum.

A continuous signal may be represented as discrete samples for digital processing, transmission, etc. If the original signal x(t) has a bounded spectrum with a maximum frequency F/2, then, according to Kotelnikov (Nyquist - Shannon) theorem, it can be unambiguously, and without loss, restored over its discrete samples taken with a frequency strictly greater than F. More particularly, if the samples are taken with a period $T = \frac{2\pi}{F}$, then the following expression is true:

$$x(t) = \sum_{k=-\infty}^{\infty} x(kT) \cdot sinc\left(\frac{\pi}{T}(t - kT)\right) \tag{1}$$

where

$$sinc(t) = \begin{cases} \frac{\sin(t)}{t}, & t \neq 0 \\ 1, & t = 0 \end{cases} \tag{2}$$

Despite the fact that the theorem implies an infinite sum, in practice it appears reasonable to pick out a sufficiently large window size, and the larger the window size, the closer the result to the theoretical value.

In some instances, it may be desirable to vary the sampling frequency though, for convenience, the period may be used for illustration rather than the frequency. The original sampling period may be denoted by $T_s$, thus the signal values may be known at instants of time $T_s \cdot k, k \in Z$. The sampling period, which is to be obtained, may be denoted by $T_d$. i.e. the signal values x(t) at instants of time $T_d \cdot n, n \in Z$ are to be calculated.

With decreasing the frequency (increasing the period), it may be necessary to ensure that the signal spectrum still satisfies the conditions of the theorem for the new sampling frequency. Therefore, low frequencies should be filtered. Fortunately, sincfunction is a low-pass filter. So, for example, in order to decrease the sampling frequency (accordingly, increase the period, $T_d > T_s$), it may be sufficient to calculate (1) in points $T_d \cdot n$ by substituting $\frac{\pi \cdot T_s}{T_d}$ for the multiplier $\frac{\pi}{T_s}$.

For practical implementation, equation (1) may be rewritten in the approximate form:

$$\hat{x}(t) = \sum_{k=-N/2}^{N/2} x(k \cdot T_s) \cdot sinc(K \cdot (t - k \cdot T_s)) \tag{3}$$

where

$$K = \begin{cases} \dfrac{\pi \cdot T_s}{T_d}, & T_d \geq T_s \\ \pi, & T_d < T_s \end{cases} \qquad\qquad (4)$$

The resulting signal $\hat{x}(t)$ is marked with a "hat" in equation (3) as it still is different from the original signal, i.e. samples of which arc available. This difference is dictated, in one instance, by filtering and, in another instance, by inevitable distortions that are introduced by the finite sum. A smoothing window can also be applied, if desired.

One shortcoming of resampling may be solved, in some instances, using equation (3). However, if a sufficiently large N is taken, this convolution will be very resource-intensive. Firstly, it will require N multiplications by each sample and, secondly, the values of sinc-function will have to be computed, at worst, for each calculated sample. Efficient computation is possible only if the convolution kernels are computed in advance, and the convolutions themselves are optimized, for example, in accordance with the properties of the Fourier transform.

With certain ratios of sampling frequencies (periods), the number of convolution kernels can be reduced. For example, if it is necessary to obtain the frequency Fd, given the initial frequency Fs, and the ratio Q=Fs/Fd is an integer, one kernel can be needed and it can be calculated once. The resulting samples will be Q times less in number and they can be normally calculated using equation (3) for each t=Q*Ts*n. In practice, it may be easier to perform convolution for each original sample, using the properties of fast Fourier transform (FFT), and then take every Qth sample, i.e. perform decimation. In doing so, the convolution kernel is calculated only once. Increasing the frequency by an integer number of times is not likely to present any difficulties.

With a rational frequency ratio, i.e. when the initial Fs and final Fd frequencies are integers, but not multiples of each other, it may be possible to perform a two-pass resampling. First, the frequency must be increased until the frequency, which is the greatest common multiple of Fs and Fd, is achieved, and then reduced to the required value. Each of these operations changes the frequency by a factor of an integer. One disadvantage of this approach is that the least common multiple can be very large and, therefore, huge amounts of data will have to be processed.

For rational frequency ratios, the so-called polyphase filters can also be used. Technical implementations may vary, so presented herein is the basic concept. Looking at the argument of sinc - function in equation (3), it may be apparent that the fractional part $\dfrac{t - k \cdot T_s}{T_s}$ is repeated. Thus, kernels may be calculated for all possible phases and then new samples computed using equation (3). However, this process may be difficult, and may not be versatile. In addition, the properties of FFT cannot always be used efficiently, since most of the calculated data is lost during decimation.

There are also methods of signal approximation in the areas corresponding to the new samples. Farrow filters can be used, as an example. However, such methods, though computationally simple, may give a very inaccurate result.

It is emphasized that all of the above methods are not universal or do not, in principle, provide an exact calculation. Versatile and precise methods may be achieved, for example, only through direct implementation of equation (3). Accordingly, there exists a need for a relatively simple, but versatile and precise, method for resampling of a signal.

BRIEF SUMMARY OF THE DISCLOSURE

The above and other needs are met by aspects of the present disclosure, wherein one such aspect relates to a method which allows the original signal to be calculated over discrete samples with arbitrary accuracy (provided the conditions of Kotelnikov theorem are fulfilled). Polyphase filtering is not used in such a method in accordance with various example embodiments disclosed herein. In some example implementations disclosed herein, such a method may be used for arbitrary (including irrational) variation of sampling rate of the signal with a bounded spectrum. Direct application of Kotelnikov (Nyquist-Shannon) theorem may also provide similar results. However, with a large window being required for a qualitative result through direct application of the Kotelnikov theorem, aspects of the disclosed methods allow much faster calculation than provided by previous approaches.

In some instances, the calculation may be performed according to the Kotelnikov theorem but, instead of discrete signal convolutions with kernels having different phases, a function series expansion, such as a Taylor expansion, may be used. Fast operation may be achieved in such example embodiments using a small number of filters, whose kernels can be computed at the beginning of the process, and effective use of the properties of FFT, since no subsequent decimation is required. As an example in accordance with some example embodiments, let the initial sampling period be a time unit, then, after calculating the signal derivatives at each integer point, it becomes possible to perform Taylor expansion in the neighborhood of each integer point. Thus, in accordance with such example embodiments, for any point in time, the nearest integer point may be found and the value calculated with any given accuracy.

In a first aspect of the invention, a method for calculating a sampled signal is provided. The method includes determining a plurality of discrete samples of a continuous signal having a finite spectrum; determining coefficients of a function series expansion of the continuous signal by applying a Fast Fourier Transform, FFT, to perform convolutions of the plurality of discrete samples with a plurality of derivatives of a sinc function; and using the function series expansion to calculate at least a portion of the continuous signal over the plurality of discrete samples.

In a second aspect of the invention an apparatus comprising processing circuitry is provided. The processing circuitry of this example embodiment is configured to control the apparatus to: determine a plurality of discrete samples of a continuous signal having a finite spectrum; determine coefficients of a function series expansion of the continuous signal by applying a Fast Fourier Transform, FFT, to perform convolutions of the plurality of discrete samples with a plurality of derivatives of a sinc function; and use the function series expansion to calculate at least a portion of the continuous signal over the plurality of discrete samples.

In a third aspect of the invention a computer program product comprising at least one non-transitory computer readable storage medium having computer program code stored thereon. The program code includes program code for performing the method for calculating a sampled signal.

In a fourth aspect of the invention an apparatus is provided. The apparatus of this example embodiment includes means for determining a plurality of discrete samples of a continuous signal having a finite spectrum means for determining coefficients of a function series expansion of the continuous signal by applying a Fast Fourier Transform, FFT, to perform convolutions of the plurality of discrete samples with a plurality of derivatives of a sinc function; and means for using the function series expansion to calculate at least a portion of the continuous signal over the plurality of discrete samples.

Aspects of the present disclosure thus address the identified needs and provide other advantages as otherwise detailed herein. It will be appreciated that the above summary is provided merely for purposes of summarizing some example embodiments so as to provide a basic understanding of some aspects of the disclosure. As such, it will be appreciated that the above described example embodiments are merely examples and should not be construed to narrow the scope of the disclosure in any way. It will be appreciated that the scope of the disclosure encompasses many potential embodiments, some of which will be further described below, in addition to those here summarized.

BRIEF DESCRIPTION OF THE SEVERAL VIEWS OF THE DRAWINGS

Having thus described the disclosure in general terms, reference will now be made to the accompanying drawings, which are not necessarily drawn to scale, and wherein:

FIG. 1 schematically illustrates sampling periods, according to one aspect of the disclosure;

FIG. 2 schematically illustrates convolution kernels used to calculate derivatives, according to one aspect of the disclosure;

FIG. 3 schematically illustrates a calculation of derivatives of the signal, according to one aspect of the disclosure; with a plurality of derivatives of a sinc function; and

FIG. 4 illustrates a flowchart according to an example method for calculating a sampled signal according to some example embodiments;

FIG. 5 illustrates a flowchart according to an example method for using a function series expansion to calculate a sampled signal according to some example embodiments;

FIG. 6 illustrates a block diagram of an apparatus for calculating a sampled signal according to some example embodiments; and

**FIG. 7** illustrates an example system according to some example embodiments.

DETAILED DESCRIPTION OF THE DISCLOSURE

The present disclosure now will be described more fully hereinafter with reference to the accompanying drawings, in which some, but not all aspects of the disclosure are shown. Indeed, the disclosure may be embodied in many different forms and should not be construed as limited to the aspects set forth herein; rather, these aspects are provided so that this disclosure will satisfy applicable legal requirements. Like numbers refer to like elements throughout.

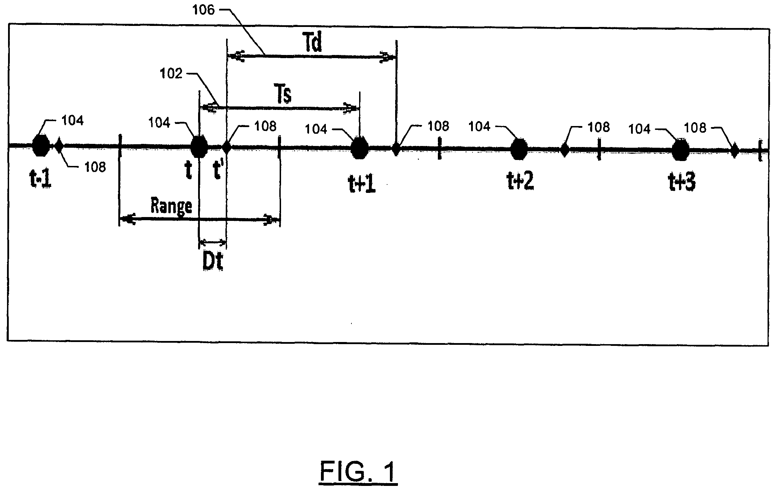

Aspects of the present disclosure are generally directed to apparatuses and methods for calculating signal values at instants of time $T_d \cdot n$ given the values $T_s \cdot k$ (with possible filtering, at lowering the frequencies). Without loss of generality, the initial period may be assumed as $T_s = 1$. Hereinafter, the time may be measured in the initial sampling

periods $T_s$ (see, e.g., Fig.1).

In Fig.1, the time of initial samples, with a period $T_s$ 102 ($T_s$= 1), is marked with large circles 104 and the time of samples whose values are to be calculated, with a period $T_d$ 106, is marked with small circles 108. As mentioned above, the initial period is considered a unit, so each sample can be associated with a neighborhood of range 1/2. For instance, point t is associated with the neighborhood [t - 1/2, t + 1/2). In this regard, the point t can be considered as a center point of a neighborhood having an interval length corresponding to the initial period. Let point t be the origin of coordinates, then t' has the coordinate Dt. Any calculated point $T_d \cdot n$ lies in the neighborhood of range 1/2 of some known point $T_s \cdot k$.

Since we assume that the original signal x(t) (as well as filtered $\hat{x}(t)$) satisfies the Kotelnikov theorem and has a finite spectrum, it is an infinitely differentiable function. Therefore, the original signal can be expanded using a function series expansion. For example, we can expand the Taylor series of the original signal in the neighborhood of any point with the known derivatives:

$$x(t) = \sum_{m=0}^{\infty} \frac{x^{(m)}(k \cdot T_s) \cdot t^m}{m!} = \sum_{m=0}^{\infty} \frac{x^{(m)}(k) \cdot t^m}{m!}, k \in Z \tag{5}$$

If we take the nearest known point, in whose neighborhood lies the calculated point, as the origin of coordinates, then the expansion will be in the neighborhood of zero.

To perform the expansion, the derivatives of the calculated signal should be computable. To calculate the signal itself (perhaps, with filtering), using equation (3), it is necessary to perform convolution of the sampled version with sinc-function. Let * denote convolution, D - differentiation. According to the properties of the convolution, the following equation is true:

$$D(f*g) = D(f)*g = f*D(g) \tag{6}$$

Note that sinc-function is an infinitely differentiable function. Consider some of its derivatives:

$$sinc^{(0)}(x) = \frac{\sin(x)}{x}$$

$$sinc^{(1)}(x) = \frac{x \cdot \cos(x) - \sin(x)}{x^2}$$

$$sinc^{(2)}(x) = \frac{2 \cdot x \cdot \cos(x) + (x^2 - 2) \cdot \sin(x)}{x^3}$$

etc. In order not to complicate the equation, the value is not explicitly defined at 0, though it may be assumed that the function may be continued by continuity at 0.

From equations (3) and (6), the calculation of the derivatives follows. Convolving a sampled signal with the derivatives of sinc-function, the derivatives of the original continuous signal x(t) (or, more exactly, $\hat{x}(t)$ since a finite sum is present and filtering might have been performed) may be obtained.

Fast calculation

In calculation, the values of the function and its derivatives taken only at the integer points are required, so equation (3) can be rewritten as follows:

$$\hat{x}^{(m)}(n) = \sum_{k=N/2}^{N/2} x(k) \cdot sinc^{(m)}(-K \cdot (n - k)) \tag{7}$$

As in choosing the window size in equations (3) or (7), the infinite series may be bound by a partial sum. Then, equation (5) can be written as follows:

$$\hat{x}(t) = \sum_{m=0}^{M} \frac{\hat{x}^{(m)}(k) \cdot t^m}{m!} \tag{8}$$

In practice, when choosing $M$, account can be taken of the accuracy of the implemented calculations as well as the efficiency/quality ratio (which is often subjective). In this regard, in some example embodiments, $M$ may be selected based at least in part on one or more of a desired threshold accuracy level or a harmonic complexity of the signal.

Since the derivative values are required only at integer points, and the phases of convolution kernels do not depend on the initial and final sampling rates, it may be unnecessary to calculate a large number of nearly identical kernels, differing only in phase. In accordance with some example embodiments, the convolution kernels may be the same at any increase in the frequency, and with lowering the frequency the convolution kernels may differ only due to the need of filtering. Such example embodiments can provide several benefits, including that the convolution kernels are few in number, do not change during resampling of the entire signal, and no subsequent decimation of the results of convolution optimized with FFT is required. In some instances, the M convolution kernels may be pre-calculated (according to the number of used coefficients of the series). In the course of operation, the convolutions may be computed using FFT, thus giving the derivatives directly in N integer points (e.g., the size of the FFT window), and then the values of samples may be calculated by series summation. Each individual sample requires only $M$ multiplications and additions (hereinafter, operations).

In some aspects, a more accurate formula describing the total computational costs per sample obtained may be derived. The initial and final frequencies may be denoted as Fs and Fd, respectively. If the signal is processed as pieces, N samples each, then each such piece will result in $N*Fd/Fs$ resampled samples. Calculation of one derivative for $N$ initial samples may cost approximately $N+N*\log_2(N)$ operations (point-wise multiplication, inverse FFT). Since M derivatives may be used, as well as calculation of the direct FFT from the source signal, computation of the same for N points may cost $N*\log_2(N) +(N+N*\log_2(N))*M$ operations. Altogether, for only one point the following operations may be consumed:

$$\frac{N*log2(N) +(N+N*log2(N))*M+N*\frac{Fd}{Fs}*M}{N} = log2(N) + (1 + log2(N)) * M + \frac{Fd}{Fs} * M \tag{9}$$

In experiments with some example embodiment, $M$=9 appeared enough for the result to be better than that of the known sound editors (pure, in terms of spectrum reflection). In these experiments, the convolution window was taken as 8192. It will be appreciated, however, that other values of M and/or other convolution windows may be used in various example embodiments. For example, $M$ may be selected in various implementations based at least in part on a desired threshold accuracy level, a harmonic complexity of the signal, and/or other factors. In using equation (3) directly, N operations per each sample will be required for the convolution only, in addition to the need to calculate sinc-functions. Optimization of the convolution due to the properties of FFT may not work in the general case, as the kernels may be unique for each sample.

Note that aspects of the method of some example embodiments allow both decreasing and increasing the sampling frequency. For such variation of the sampling frequency, consideration may be taken to account for correct assignment of the coefficient $K$ that is responsible for low-pass filtering. $K$ can, for example, be defined in accordance with equation (4). As can be seen from equation (4), $K$ can differ when decreasing and increasing the sampling rate. If the sampling rate is increased, then there may not be any risk of aliasing, and the current frequency can be taken for the Nyquist frequency. If, however, the sampling rate is reduced, it may be necessary to remove the high frequencies that cannot be transferred at the new (lower) sampling rate. The ratio of Ts/Td describes how many times the Nyquist frequency will change. When reducing the sampling rate, filtering may be needed. Therefore, the sinc-function may be "stretched" over time by a factor of Ts/Td. Thus, the coefficient $K$ may be used to regulate the frequency range to be resampled, adjusting the frequency range to the new Nyquist frequency.

When calculating $K$ according to equation (4), the result may be the Kotelnikov (Nyquist) theorem, per se, with increasing sampling rate, whereas decreasing the sampling rate may cause low-pass filtering down to the new Nyquist frequency. If the lower value of $K$ is selected, then the high frequencies that are possible to transfer with the new sampling rate may be removed from signal. In this regard, data loss may occur. If the higher value of $K$ is selected, then spectrum reflection may occur. As an example, consider a signal with a sampling rate of 22,050 Hz. If the sampling rate is lowered to 12,000 Hz, elimination of frequencies above 6,000 Hz may be desired. If the coefficient $K$ is assigned incorrectly and

remains equal to $\pi$, spectrum reflection may occur.

If N=8192 and M=9 are substituted in equation (9) and Fd/Fs assumed to be close to unity, then 148 operations per sample are obtained. In some aspects, practical applications may allow less accuracy, and may be considered the least optimal option. In some cases it may be possible to reduce computations without calculating obvious null terms of series.

With decreasing the frequency by a multiple number of times $\left( \frac{T_d}{T_s} = \frac{F_s}{F_d} \in N \right),$ only the 0th term of the series will be nonzero, so in this case the operation can be quickened without calculating higher derivatives. Also, with greater decrease in the frequency (more than twofold), in terms of efficiency it appears reasonable to perform two-pass resampling. On the first pass, the frequency decreases by a maximum integer number of times until the frequency higher than the final frequency is achieved. In doing so, the calculation of derivatives is not required, and the whole operation runs almost M times faster than during complete decomposition. The second pass may be used to perform resampling with all its derivatives, but in that case, the initial data is already substantially reduced. For instance, in order to convert the frequency of 44100 to 8000, the amount of data should first be reduced five-fold by lowering the frequency from 44100 to 8820.

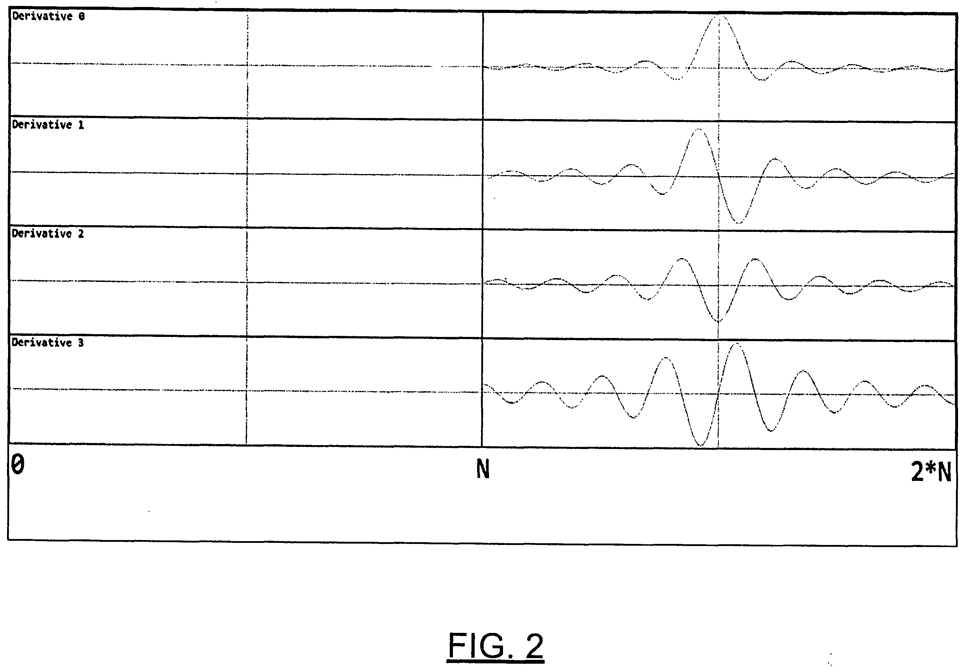

Fig. 2 shows example convolution kernels that may be used to calculate the derivatives, representing the derivatives of sinc-function, in accordance with some example embodiments. Given the window size $N,$ in order to speed up computation using the fast Fourier transform, zeroes may be added to the kernel from one end and the fast Fourier transform performed with a double window. In Fig. 2, the sinc-function derivatives themselves are presented non-scaled for more clarity. Before starting, the Fourier transform of the derivatives of sinc-functions may be calculated with added zeroes. Also, to ensure accuracy, it may be reasonable that a smoothing window be applied, e.g. $\frac{1}{2} + \frac{1}{2}\cos\left(\frac{2 \cdot \pi \cdot t}{N}\right)$.

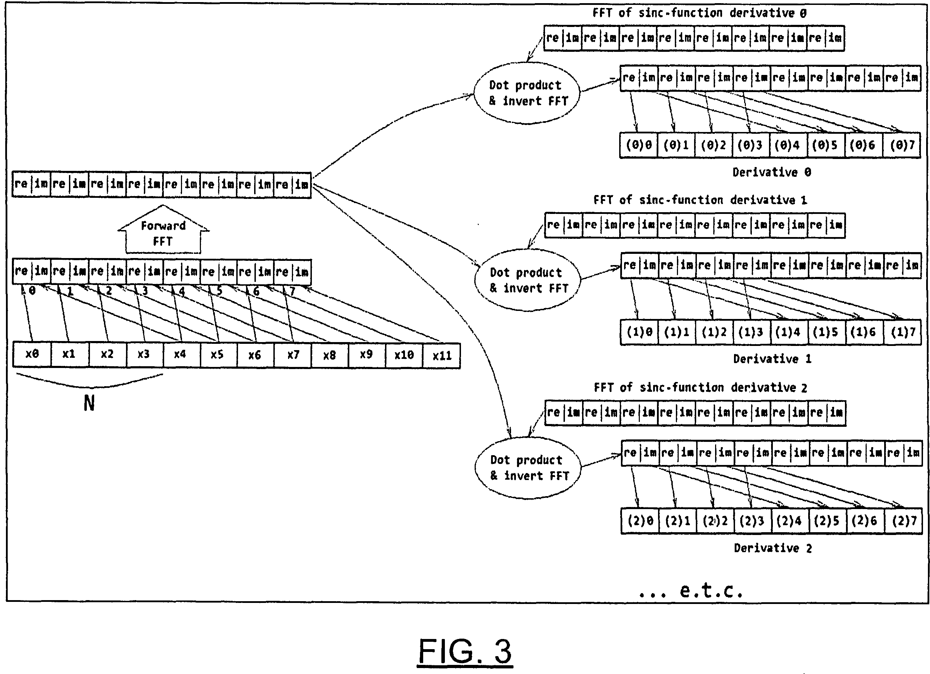

Once the Fourier transforms for the convolution kernels have been calculated, the derivatives of the signal itself can be computed, as shown in Fig. 3. In the illustrated example, a very small window $N$=4 is used. The derivatives for $N*2$ points are calculated in one step. For the imaginary part to be involved, it is filled with the data with displacement N relative to the real part. After resorting, the direct Fourier transform may be performed. The point-wise multiplication may then be run for each derivative, using Discrete Fourier Transform (DFT) of the corresponding sinc-function derivative, followed by the inverse Fourier transform. After that, the real and imaginary parts may be separated, resulting in $2*N$ values for each derivative.

To calculate each new sample, its time relative to the beginning of the block may be determined with the calculated derivatives in the initial periods. If the time is greater than the calculated block, the next $2*N$ derivatives may then be computed. If the current sample falls within the calculated block, the point in whose neighborhood lies the present sample may be found and calculated according to equation (8).

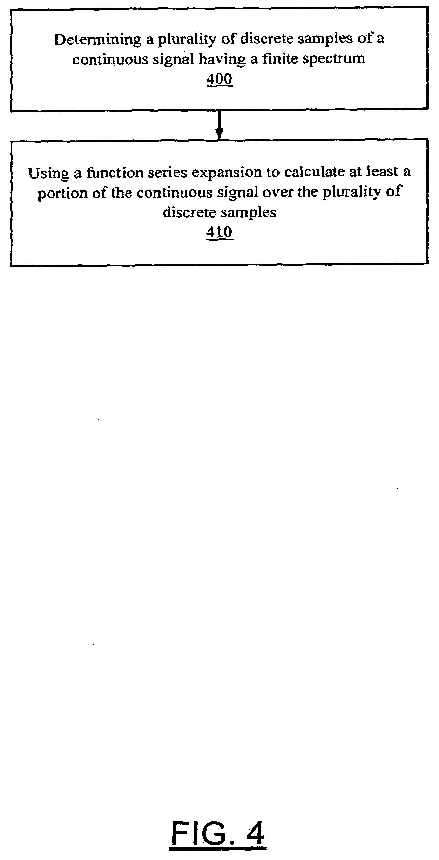

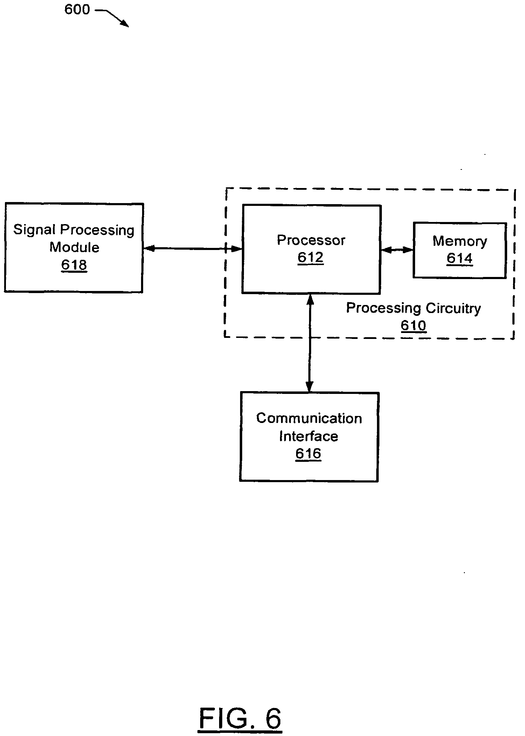

FIG. 4 illustrates a flowchart according to an example method for calculating a sampled signal according to some example embodiments. Operation 400 may include determining a plurality of discrete samples of a continuous signal having a finite spectrum. The discrete samples may, for example, be representative of the continuous signal at a first sampling rate at which the signal may be received or otherwise accessed. The continuous signal may, for example, be received over a channel. For example, the continuous signal may be received by a computing device over a wireless network. The continuous signal may, for example, carry digital audio data. For example, the continuous signal may be representative of audio data for a digital audio file that may be streamed over a network. It will be appreciated, however, that the continuous signal may carry other data types in addition to or in lieu of audio data in accordance with various embodiments. Operation 410 may include using a function series expansion to calculate at least a portion of the continuous signal over the plurality of discrete samples. In some example embodiments, the function series expansion used in operation 410 may be a Taylor series expansion. However, it will be appreciated that other types of function series expansions may be used in accordance with various example embodiments. In some example embodiments, the coefficients of the function series expansion may be determined by applying a FFT to perform convolutions with a plurality of sinc-function derivatives. One or more of processing circuitry 610, processor 612, memory 614, or signal processing module 618, which are illustrated in and described below with respect to FIG. 6, may, for example, provide means for performing operations 400 and 410.

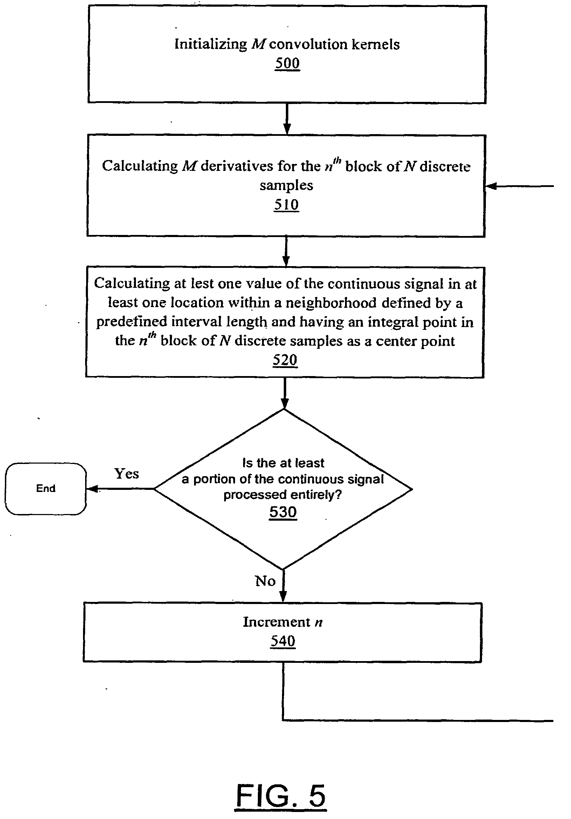

FIG. 5 illustrates a flowchart according to an example method for using a function series expansion to calculate a sampled signal according to some example embodiments. In this regard, FIG. 5 illustrates operations that may be performed attendant to performance of operation 410 in accordance with some example embodiments. In the method of FIG. 5, time may be measured during periods of sampling the original continuous signal. The window size $N,$ such as may be used in equation (7) may be determined. The signal may have a length of $N*K$ samples. In an instance in which the signal length is not a multiple of the window length $N,$ the signal may be padded, such as with zeros.

With reference to FIG. 5, operation 500 may include initializing M convolution kernels. $M$ may, for example, be selected based at least in part on one or more of a desired threshold accuracy level for computation of the original continuous signal or a harmonic complexity of the signal. For example, $M$ may be selected so that the accuracy of the function series expansion (e.g., in accordance with equation (8)) within a neighborhood defined by a predefined interval length having an integral point as a center point (e.g., within a range of ½ of the integral point) may satisfy the desired threshold accuracy level. Operation 510 may include calculating $M$ derivatives for the $n^{th}$ block of N discrete samples. Operation 520 may include calculating at least one value of the continuous signal in at least one location within a neighborhood defined by a predefined interval length and having an integral point in the $n^{th}$ block of $N$ discrete samples as a center point. Operation 530 may include determining if the at least a portion of the continuous signal to be calculated has been processed entirely. If it is determined at operation 530 that the at least a portion of the continuous signal to be calculated has been processed entirely, the method may terminate. If, however, it is determined at operation 530 that the at least a portion of the continuous signal to be calculated has not been processed entirely, the method may proceed to operation 540, in which n may be incremented, and the method may then return to operation 510. Accordingly, operations 510 and 520 may be repeated for each $n^{th}$ block of N discrete samples until the at least a portion of the continuous signal to be calculated has been processed entirely. The blocks of discrete samples may be non-intersecting. One or more of processing circuitry 610, processor 612, memory 614, or signal processing module 618, which are illustrated in and described below with respect to FIG. 6, may, for example, provide means for performing operations 500 and 540.

In some example embodiments, the sampling frequency of a primary grid of the discrete samples may be varied, such as with an arbitrary, including irrational, ratio of frequencies. However, the same set of M convolution kernels initialized in operation 500 may be used for resampling of the entirety of the at least a portion of the continuous signal regardless of the variation of sampling frequency.

It will be understood that each block of the flowcharts in FIGs. 4 and 5, and combinations of blocks in the flowcharts, may be implemented by various means, such as hardware and/or a computer program product comprising one or more computer-readable mediums having computer readable program instructions stored thereon. For example, one or more of the procedures described herein may be embodied by computer program instructions of a computer program product. In this regard, the computer program product(s) which may embody the procedures described herein may be stored by one or more memory devices of a mobile terminal, server, or other computing device and executed by a processor in the computing device. In some embodiments, the computer program instructions comprising the computer program product(s) which embody the procedures described above may be stored by memory devices of a plurality of computing devices. As will be appreciated, any such computer program product may be loaded onto a computer or other programmable apparatus to produce a machine, such that the computer program product including the instructions which execute on the computer or other programmable apparatus creates means for implementing the functions specified in the flowchart block(s). Further, the computer program product may comprise one or more computer-readable memories on which the computer program instructions may be stored such that the one or more computer-readable memories can direct a computer or other programmable apparatus to function in a particular manner, such that the computer program product comprises an article of manufacture which implements the function specified in the flowchart block(s). The computer program instructions of one or more computer program products may also be loaded onto a computer or other programmable apparatus to cause a series of operations to be performed on the computer or other programmable apparatus to produce a computer-implemented process such that the instructions which execute on the computer or other programmable apparatus implement the functions specified in the flowchart block(s). Accordingly, blocks of the flowcharts support combinations of means for performing the specified functions. It will also be understood that one or more blocks of the flowcharts, and combinations of blocks in the flowcharts, may be implemented by special purpose hardware-based computer systems which perform the specified functions, or combinations of special purpose hardware and computer program product(s).

FIG. 6 illustrates a block diagram of an apparatus 600 that may be configured to calculate a sampled signal in accordance with some example embodiments. It will be appreciated that the components, devices or elements illustrated in and described with respect to FIG. 6 below may not be mandatory and thus some may be omitted in certain embodiments. Additionally, some embodiments may include further or different components, devices or elements beyond those illustrated in and described with respect to FIG. 6.

In some example embodiments, the apparatus 600 may include processing circuitry 610 that is configurable to perform actions in accordance with one or more example embodiments disclosed herein. In this regard, the processing circuitry 610 may be configured to perform and/or control performance of one or more functionalities of apparatus 600 in accordance with various example embodiments. Thus, the processing circuitry 610 may be configured to perform data processing, application execution and/or other processing and management services according to one or more example embodiments. As such, the processing circuitry 610 may provide means for performing resampling and signal calculation methods in accordance with various example embodiments. For example, the processing circuitry 610 and/or one or more other components of the apparatus 600 may provide means for performing one or more of the operations illustrated in and described with respect to FIGs. 4 and 5.

In some embodiments, the apparatus 600 or a portion(s) or component(s) thereof, such as the processing circuitry 610, may include one or more chipsets, which may each include one or more chips. The processing circuitry 610 and/or one or more further components of the apparatus 600 may therefore, in some instances, be configured to implement an embodiment on a chipset. For example, the apparatus 600, or portion thereof, may be implemented on a sound card, analog-to-digital audio converter, audio processor, or the like.

In some example embodiments, the processing circuitry 610 may include a processor 612 and, in some embodiments, such as that illustrated in FIG. 6, may further include memory 614. The processing circuitry 610 may be in communication with or otherwise control a communication interface 616 and/or signal processing module 618.

The processor 612 may be embodied in a variety of forms. For example, the processor 612 may be embodied as various processing means such as a microprocessor, a coprocessor, a controller or various other computing or processing devices including integrated circuits such as, for example, an ASIC (application specific integrated circuit), an FPGA (field programmable gate array), some combination thereof, or the like. Although illustrated as a single processor, it will be appreciated that the processor 612 may comprise a plurality of processors. The plurality of processors may be in operative communication with each other and may be collectively configured to perform one or more functionalities of the apparatus 600. In embodiments including a plurality of processors, the processors may be implemented on a single computing device, or may be distributed across a plurality of computing devices that may be collectively configured to provide functionality of the apparatus 600 in accordance with some example embodiments. In some example embodiments, the processor 612 may be configured to execute instructions that may be stored in the memory 614 or that may be otherwise accessible to the processor 612. As such, whether configured by hardware or by a combination of hardware and software, the processor 612 capable of performing operations according to various embodiments while configured accordingly.

In some example embodiments, the memory 614 may include one or more memory devices. In embodiments including multiple memory devices, the memory devices may be implemented on a single computing device, or may be distributed across a plurality of computing devices that may be collectively configured to provide functionality of the apparatus 600 in accordance with some example embodiments. Memory 614 may include fixed and/or removable memory devices. In some embodiments, the memory 614 may provide a non-transitory computer-readable storage medium that may store computer program instructions that may be executed by the processor 612. In this regard, the memory 614 may be configured to store information, data, applications, instructions and/or the like for enabling the apparatus 600 to carry out various functions in accordance with one or more example embodiments. In some embodiments, the memory 614 may be in communication with one or more of the processor 612, communication interface 616, or signal processing module 618 via a bus(es) for passing information among components of the apparatus 600.

The apparatus 600 may further include a communication interface 616. The communication interface 616 may enable the apparatus 600 to receive a signal that may be sent by another computing device, such as over a network. In this regard, the communication interface 616 may include one or more interface mechanisms for enabling communication with other devices and/or networks. As such, the communication interface 616 may include, for example, an antenna (or multiple antennas) and supporting hardware and/or software for enabling communications with a wireless communication network (e.g., a cellular network, WLAN, and/or the like) and/or a communication modem or other hardware/software for supporting communication via cable, digital subscriber line (DSL), USB, FireWire, Ethernet or other wireline networking methods.

The apparatus 600 may further include signal processing module 618. The signal processing module 618 may be embodied as various means, such as circuitry, hardware, a computer program product comprising computer readable program instructions stored on a computer readable medium (for example, the memory 614) and executed by a processing device (for example, the processor 612), or some combination thereof. In some embodiments, the processor 612 (or the processing circuitry 610) may include, or otherwise control the signal processing module 618. The signal processing module 618 may be configured to use a function series expansion to calculate at least a portion of a continuous signal in accordance with various embodiments. Thus, for example, the signal processing module 618 may be configured to perform one or more operations illustrated in and described with respect to FIGs. 4 and 5.

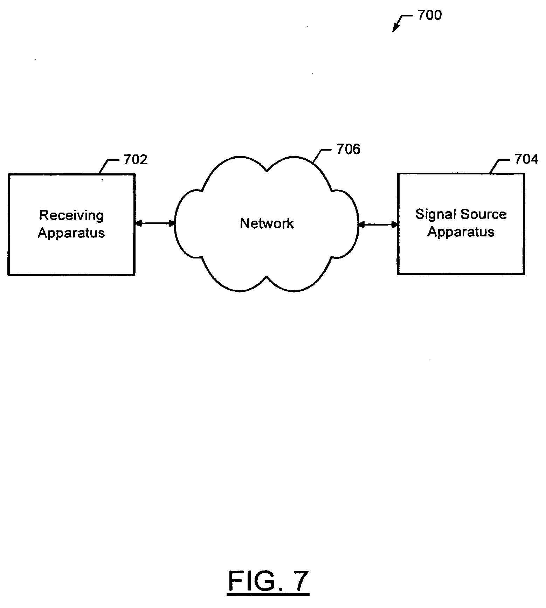

FIG. 7 illustrates an example system 700 according to some example embodiments. The system 700 can include a receiving apparatus 702 and signal source apparatus 704. The receiving apparatus 702 and signal source apparatus 704 may be configured to communicate with each other over a network 706. The network 706 may, for example, comprise a wireline network, wireless network (e.g., a cellular network, wireless local area network, wireless wide area network, some combination thereof, or the like), or a combination thereof, and in some example embodiments may comprise the Internet.

The signal source apparatus 704 may comprise a server or other computing device that may be configured to send a signal to the receiving apparatus 702 over the network 706. For example, the signal source apparatus 704 may stream digital audio to the receiving apparatus 702. The receiving apparatus 702 may comprise any computing device configured to receive a signal sent by the signal source apparatus 704. By way of non-limiting example, the receiving apparatus 702 may be embodied as a desktop computer, laptop computer, or a mobile computing device, such as a smart phone, tablet computing device, or other wireless mobile computing device.

In some example embodiments, the apparatus 600 may be implemented on the receiving apparatus 702. As such, the receiving apparatus 702 may be configured to perform resampling and signal determination operations for a signal received from the signal source apparatus 704 in accordance with various example embodiments. In embodiments in which the receiving apparatus 702 is implemented as a mobile computing device or other computing device that may be power constrained and/or processing power constrained, such as due to size limitations, a finite battery life, and/or other factors, the receiving apparatus 702 may benefit from the technical effect of the computational efficiency provided by various example embodiments. In this regard, the reduced computational complexity provided by some example embodiments may reduce power consumption by such a device. Further, the reduced computational complexity provided by some example embodiments may enable faster, more accurate signal resampling to be performed on mobile devices having relatively limited processing power.

Many modifications and other embodiments of the inventions set forth herein will come to mind to one skilled in the art to which these inventions pertain having the benefit of the teachings presented in the foregoing descriptions and the associated drawings. Therefore, it is to be understood that the embodiments of the invention are not to be limited to the specific embodiments disclosed and that modifications and other embodiments are intended to be included within the scope of the invention. Moreover, although the foregoing descriptions and the associated drawings describe example embodiments in the context of certain example combinations of elements and/or functions, it should be appreciated that different combinations of elements and/or functions may be provided by alternative embodiments without departing from the scope of the invention. In this regard, for example, different combinations of elements and/or functions than those explicitly described above are also contemplated within the scope of the invention. Although specific terms are employed herein, they are used in a generic and descriptive sense only and not for purposes of limitation.

**Claims**

1. A method for calculating a sampled signal, the method comprising:

   determining a plurality of discrete samples of a continuous signal having a finite spectrum;
   determining coefficients of a function series expansion of the continuous signal by applying a fast Fourier transform (FFT) to perform convolutions of the plurality of discrete samples with a plurality of derivatives of a sinc function; and
   using the function series expansion to calculate at least a portion of the continuous signal over the plurality of discrete samples.

2. The method of claim 1, wherein the function series expansion comprises a Taylor series expansion.

3. The method of any of claims 1 to 2, wherein determining coefficients of the function series expansion and using the function series expansion to calculate at least a portion of the continuous signal over the plurality of discrete samples comprise:

   initializing a number, M, of convolution kernels representing the plurality of derivatives of the sinc function;
   calculating M derivatives of the continuous signal for a block of a number, N, of the plurality of discrete samples at least in part by applying the FFT to the convolution kernels, wherein N is equal to a window size of the FFT; and
   calculating at least one value of the continuous signal in at least one location within a neighborhood defined by a predefined interval length and having an integral point in the block of N discrete samples as a center point.

4. The method of claim 3, further comprising repeatedly calculating M derivatives for a subsequent block of N discrete samples and calculating at least one value of the continuous signal in at least one location within a neighborhood defined by the predefined interval length and having an integral point in the subsequent block of N discrete samples as a center point until the at least a portion of the continuous signal is processed entirely.

5. The method of any of claims 3 to 4, wherein M is selected based at least in part on a desired threshold accuracy level and a harmonic complexity of the continuous signal.

6. The method of any of claims 1 to 5, further comprising varying sampling frequency of a primary grid of the discrete samples with an arbitrary, including irrational, ratio of frequencies.

7. The method of any of claims 1 to 6, wherein a common set of M convolution kernels is used for resampling of an entirety of the at least a portion of the continuous signal regardless of variation in sampling frequency during resampling.

8. The method of any of claims 1 to 7, wherein the continuous signal carries digital audio data.

9. The method of any of claims 1 to 8, wherein calculation of the at least a portion of the continuous signal is performed on a mobile computing device for a signal received by the mobile computing device over a wireless network.

10. A computer program product comprising at least one computer readable storage medium having computer program code stored thereon, the computer program code comprising program code for performing the method of any of claims 1 to 9.

11. An apparatus comprising:

means for determining a plurality of discrete samples of a continuous signal having a finite spectrum;
means for determining coefficients of a function series expansion of the continuous signal by applying a fast Fourier transform (FFT) to perform convolutions of the plurality of discrete samples with a plurality of derivatives of a sinc function; and
means for using the function series expansion to calculate at least a portion of the continuous signal over the plurality of discrete samples.

12. The apparatus of claim 11, wherein the means for determining coefficients of the function series and the means for using the function series expansion to calculate at least a portion of the continuous signal over the plurality of discrete samples collectively comprise:

means for initializing a number, M, of convolution kernels representing the plurality of derivatives of the sinc function;
means for calculating M derivatives of the continuous signal for a block of a number, N, of the plurality of discrete samples at least in part by applying the FFT to the convolution kernels, wherein N is equal to a window size of the FFT; and
means for calculating at least one value of the continuous signal in at least one location within a neighborhood defined by a predefined interval length and having an integral point in the block of N discrete samples as a center point.

13. The apparatus of claim 12, further comprising means for repeatedly calculating M derivatives for a subsequent block of N discrete samples and calculating at least one value of the continuous signal in at least one location within a neighborhood defined by the predefined interval length and having an integral point in the subsequent block of N discrete samples as a center point until the at least a portion of the continuous signal is processed entirely.

14. The apparatus of any of claims 12 to 13, wherein M is selected based at least in part on a desired threshold accuracy level and a harmonic complexity of the continuous signal.

15. The apparatus of any of claims 11 to 14, wherein one or more of:

(i) the apparatus further comprises means for varying sampling frequency of a primary grid of the discrete samples with an arbitrary, including irrational, ratio of frequencies;
(ii) a common set of M convolution kernels are used for resampling of an entirety of the at least a portion of the continuous signal regardless of variation in sampling frequency during resampling;
(iii) the function series expansion comprises a Taylor series expansion;
(iv) the continuous signal carries digital audio data; or
(v) the apparatus is implemented on a mobile computing device and the means for calculating at least one value of the continuous signal comprises means for calculating at least one value of a signal received by the mobile computing device over a wireless network.

**Patentansprüche**

1. Ein Verfahren zum Berechnen eines abgetasteten Signals, das Verfahren umfassend:

Bestimmen einer Mehrzahl von diskreten Samples eines kontinuierlichen Signals mit einem finiten Spektrum;
Bestimmen von Koeffizienten einer Funktionsreihenentwicklung des kontinuierlichen Signals durch Anwenden einer schnellen Fourier-Transformation (FFT), um Faltungen der Mehrzahl von diskreten Samples mit einer Mehrzahl von Ableitungen einer sinc-Funktion auszuführen; und
Verwenden der Funktionsreihenentwicklung, um mindestens einen Teil des kontinuierlichen Signals über die Mehrzahl von diskreten Samples zu berechnen.

2. Das Verfahren nach Anspruch 1, wobei die Funktionsreihenentwicklung eine Taylor-Reihenentwicklung umfasst.

3. Das Verfahren nach einem der Ansprüche 1 bis 2, wobei das Bestimmen von Koeffizienten der Funktionsreihenentwicklung und das Verwenden der Funktionsreihenentwicklung, um mindestens einen Teil des kontinuierlichen Signals über die Mehrzahl von diskreten Samples zu berechnen, umfasst:

Initialisieren einer Anzahl M von Faltungskernen, welche die Mehrzahl von Ableitungen der sinc-Funktion repräsentieren;
Berechnen von M Ableitungen des kontinuierlichen Signals für einen Block einer Anzahl N von der Mehrzahl von diskreten Samples mindestens teilweise durch Anwenden der FFT auf die Faltungskerne, wobei N gleich einer Fenstergröße der FFT ist; und
Berechnen von mindestens einem Wert des kontinuierlichen Signals an mindestens einem Ort innerhalb einer Nachbarschaft, welche durch eine vordefinierte Intervalllänge definiert ist und einen integralen Punkt in dem Block von N diskreten Samples zum Mittelpunkt hat.

4. Das Verfahren nach Anspruch 3, ferner umfassend: wiederholtes Berechnen von M Ableitungen für einen Folgeblock von N diskreten Samples und Berechnen von mindestens einem Wert des kontinuierlichen Signals an mindestens einem Ort innerhalb einer Nachbarschaft, welche durch die vordefinierte Intervalllänge definiert ist und einen integralen Punkt in dem Folgeblock von N diskreten Samples zum Mittelpunkt hat, bis der mindestens eine Teil des kontinuierlichen Signals vollständig abgearbeitet ist.

5. Das Verfahren nach einem der Ansprüche 3 bis 4, wobei M ausgewählt ist basierend mindestens teilweise auf einem gewünschten Schwellenwertgenauigkeitsgrad und einer harmonischen Komplexität des kontinuierlichen Signals.

6. Das Verfahren nach einem der Ansprüche 1 bis 5, ferner umfassend:

Variieren der Abtastfrequenz eines primären Gitters der diskreten Samples mit einem willkürlichen, einschließlich irrationalen, Frequenzverhältnis.

7. Das Verfahren nach einem der Ansprüche 1 bis 6, wobei ein gemeinsamer Satz von M Faltungskernen zum Neuabtasten einer Gesamtheit des mindestens einen Teils des kontinuierlichen Signals verwendet wird, ungeachtet der Variation der Abtastfrequenz während der Neuabtastung.

8. Das Verfahren nach einem der Ansprüche 1 bis 7, wobei das kontinuierliche Signal digitale Audiodaten trägt.

9. Das Verfahren nach einem der Ansprüche 1 bis 8, wobei die Berechnung des mindestens einen Teils des kontinuierlichen Signals an einer mobilen Recheneinrichtung für ein Signal durchgeführt wird, welches von der mobilen Recheneinrichtung über ein drahtloses Netzwerk empfangen wird.

10. Ein Computerprogrammprodukt, umfassend mindestens ein computerlesbares Speichermedium mit einem darauf gespeicherten Computerprogrammcode, wobei der Computerprogrammcode einen Programmcode zum Durchführen des Verfahrens nach einem der Ansprüche 1 bis 9 umfasst.

11. Eine Vorrichtung, umfassend:

ein Mittel zum Bestimmen einer Mehrzahl von diskreten Samples eines kontinuierlichen Signals mit einem finiten Spektrum;
ein Mittel zum Bestimmen von Koeffizienten einer Funktionsreihenentwicklung des kontinuierlichen Signals durch Anwenden einer schnellen Fourier-Transformation (FFT), um Faltungen der Mehrzahl von diskreten Samples mit einer Mehrzahl von Ableitungen einer sinc-Funktion auszuführen; und
ein Mittel zum Verwenden der Funktionsreihenentwicklung, um mindestens einen Teil des kontinuierlichen Signals über die Mehrzahl von diskreten Samples zu berechnen.

12. Die Vorrichtung nach Anspruch 11, wobei das Mittel zum Bestimmen von Koeffizienten der Funktionsreihe und das Mittel zum Verwenden der Funktionsreihenentwicklung, um mindestens einen Teil des kontinuierlichen Signals über die Mehrzahl von diskreten Samples zu berechnen, gemeinsam umfassen:

ein Mittel zum Initialisieren einer Anzahl M von Faltungskernen, welche die Mehrzahl von Ableitungen der sinc-Funktion repräsentieren;
ein Mittel zum Berechnen von M Ableitungen des kontinuierlichen Signals für einen Block einer Anzahl N von der Mehrzahl von diskreten Samples mindestens teilweise durch Anwenden der FFT auf die Faltungskerne, wobei N gleich einer Fenstergröße der FFT ist; und
ein Mittel zum Berechnen von mindestens einem Wert des kontinuierlichen Signals an mindestens einem Ort innerhalb einer Nachbarschaft, welche durch eine vordefinierte Intervalllänge definiert ist und einen integralen Punkt in dem Block von N diskreten Samples zum Mittelpunkt hat.

13. Die Vorrichtung nach Anspruch 12, ferner umfassend ein Mittel zum wiederholten Berechnen von M Ableitungen für einen Folgeblock von N diskreten Samples und Berechnen von mindestens einem Wert des kontinuierlichen Signals an mindestens einem Ort innerhalb einer Nachbarschaft, welche durch die vordefinierte Intervalllänge definiert ist und einen integralen Punkt in dem Folgeblock von N diskreten Samples zum Mittelpunkt hat, bis der mindestens eine Teil des kontinuierlichen Signals vollständig abgearbeitet ist.

14. Die Vorrichtung nach einem der Ansprüche 12 bis 13, wobei M ausgewählt ist basierend mindestens teilweise auf einem gewünschten Schwellenwertgenauigkeitsgrad und einer harmonischen Komplexität des kontinuierlichen Signals.

15. Die Vorrichtung nach einem der Ansprüche 11 bis 14, umfassend eines oder mehrere von:

(i) die Vorrichtung umfasst ferner ein Mittel zum Variieren der Abtastfrequenz eines primären Gitters der diskreten Samples mit einem willkürlichen, einschließlich irrationalen, Frequenzverhältnis;
(ii) es wird ein gemeinsamer Satz von M Faltungskernen zum Neuabtasten einer Gesamtheit des mindestens einen Teils des kontinuierlichen Signals verwendet, ungeachtet der Variation der Abtastfrequenz während der Neuabtastung;
(iii) die Funktionsreihenentwicklung umfasst eine Taylor-Reihenentwicklung;
(iv) das kontinuierliche Signal trägt digitale Audiodaten; oder
(v) die Vorrichtung ist auf einer mobilen Recheneinrichtung implementiert und das Mittel zum Berechnen von mindestens einem Wert des kontinuierlichen Signals umfasst ein Mittel zum Berechnen von mindestens einem Wert eines Signals, welches von der mobilen Recheneinrichtung über ein drahtloses Netzwerk empfangen wird.

**Revendications**

1. Procédé pour calculer un signal échantillonné, le procédé comprenant :

la détermination d'une pluralité d'échantillons distincts d'un signal continu ayant un spectre fini ;
la détermination de coefficients d'une série de fonctions expansion du signal continu en appliquant une transformée de Fourier rapide (FFT) pour effectuer des convolutions de la pluralité d'échantillons distincts avec une pluralité de dérivées d'une fonction sinus cardinal ; et
l'utilisation de la série de fonctions expansion pour calculer au moins une partie du signal continu sur une pluralité d'échantillons distincts.

2. Procédé selon la revendication 1, dans lequel la série de fonctions expansion comprend une série expansion de Taylor.

3. Procédé selon l'une quelconque des revendications 1 à 2, dans lequel la détermination de coefficients de la série de fonctions expansion et l'utilisation de la série de fonctions expansion pour calculer au moins une partie du signal continu sur la pluralité d'échantillons distincts comprennent :

l'initialisation d'un nombre, M, de noyaux de convolution représentant la pluralité de dérivées de la fonction sinus cardinal ;

le calcul de M dérivées du signal continu pour un bloc d'un nombre, N, de la pluralité d'échantillons distincts au moins en partie en appliquant la FFT aux noyaux de convolution, N étant égal à une taille de fenêtre de la FFT ; et

le calcul d'au moins une valeur du signal continu dans au moins un emplacement dans un voisinage défini par une longueur d'intervalle prédéfinie et ayant un point intégral dans le bloc de N échantillons distincts comme point central.

**4.** Procédé selon la revendication 3, comprenant en outre le calcul répété de M dérivées pour un bloc subséquent de N échantillons distincts et le calcul d'au moins une valeur du signal continu dans au moins un emplacement dans un voisinage défini par la longueur d'intervalle prédéfinie et ayant un point intégral dans le bloc subséquent de N échantillons distincts comme point central jusqu'à ce que l'au moins une partie du signal continu soit traitée entièrement.

**5.** Procédé selon l'une quelconque des revendications 3 à 4, dans lequel M est sélectionné sur la base, au moins en partie, d'un niveau de précision de seuil souhaité et d'une complexité harmonique du signal continu.

**6.** Procédé selon l'une quelconque des revendications 1 à 5, comprenant en outre la variation de la fréquence d'échantillonnage d'une grille primaire des échantillons distincts avec un rapport de fréquences arbitraire, y compris irrationnel.

**7.** Procédé selon l'une quelconque des revendications 1 à 6, dans lequel un ensemble commun de M noyaux de convolution est utilisé pour ré-échantillonner une totalité de l'au moins une partie du signal continu quelle que soit la variation de la fréquence d'échantillonnage durant le ré-échantillonnage.

**8.** Procédé selon l'une quelconque des revendications 1 à 7, dans lequel le signal continu transporte des données audio numériques.

**9.** Procédé selon l'une quelconque des revendications 1 à 8, dans lequel le calcul de l'au moins une partie du signal continu est effectué sur un dispositif informatique mobile pour un signal reçu par le dispositif informatique mobile sur un réseau sans fil.

**10.** Produit de programme d'ordinateur comprenant au moins un support de stockage lisible par ordinateur ayant un code de programme d'ordinateur stocké sur celui-ci, le code de programme d'ordinateur comprenant un code de programme pour effectuer le procédé selon l'une quelconque des revendications 1 à 9.

**11.** Appareil comprenant :

un moyen pour déterminer une pluralité d'échantillons distincts d'un signal continu ayant un spectre fini ;

un moyen pour déterminer des coefficients d'une série de fonctions expansion du signal continu en appliquant une transformée de Fourier rapide (FFT) pour effectuer des convolutions de la pluralité d'échantillons distincts avec une pluralité de dérivées d'une fonction sinus cardinal ; et

un moyen pour utiliser la série de fonctions expansion pour calculer au moins une partie du signal continu sur une pluralité d'échantillons distincts.

**12.** Appareil selon la revendication 11, dans lequel le moyen pour déterminer des coefficients de la série de fonctions et le moyen pour utiliser la série de fonctions expansion pour calculer au moins une partie du signal continu sur la pluralité d'échantillons distincts comprennent collectivement :

un moyen pour initialiser un nombre, M, de noyaux de convolution représentant la pluralité de dérivées de la fonction sinus cardinal ;

un moyen pour calculer M dérivées du signal continu pour un bloc d'un nombre, N, de la pluralité d'échantillons distincts au moins en partie en appliquant la FFT aux noyaux de convolution, N étant égal à une taille de fenêtre de la FFT ; et

un moyen pour calculer au moins une valeur du signal continu dans au moins un emplacement dans un voisinage défini par une longueur d'intervalle prédéfinie et ayant un point intégral dans le bloc de N échantillons distincts comme point central.

**13.** Appareil selon la revendication 12, comprenant en outre un moyen pour calculer de manière répétée M dérivées pour un bloc subséquent de N échantillons distincts et calculer au moins une valeur du signal continu dans au moins un emplacement dans un voisinage défini par la longueur d'intervalle prédéfinie et ayant un point intégral dans le bloc subséquent de N échantillons distincts comme point central jusqu'à ce que l'au moins une partie du signal continu soit traitée entièrement.

**14.** Appareil selon l'une quelconque des revendications 12 à 13, dans lequel M est sélectionné sur la base, au moins en partie, d'un niveau de précision de seuil souhaité et d'une complexité harmonique du signal continu.

**15.** Appareil selon l'une quelconque des revendications 11 à 14, dans lequel M est sélectionné, dans lequel il y a une ou plusieurs des caractéristiques parmi :

(i) l'appareil comprend en outre un moyen pour faire varier la fréquence d'échantillonnage d'une grille primaire des échantillons distincts avec un rapport de fréquences arbitraire, y compris irrationnel ;
(ii) un ensemble commun de M noyaux de convolution est utilisé pour ré-échantillonner une totalité de l'au moins une partie du signal continu quelle que soit la variation de la fréquence d'échantillonnage durant le ré-échantillonnage ;
(iii) la fonction expansion en série comprend une série expansion de Taylor ;
(iv) le signal continu transporte des données audio numériques ; ou
(v) l'appareil est mis en oeuvre sur un dispositif informatique mobile et le moyen de calcul d'au moins une valeur du signal continu comprend un moyen pour calculer au moins une valeur d'un signal reçu par le dispositif informatique mobile sur un réseau sans fil.

FIG. 1

FIG. 2

FIG. 3

Determining a plurality of discrete samples of a
continuous signal having a finite spectrum
400

Using a function series expansion to calculate at least a
portion of the continuous signal over the plurality of
discrete samples
410

# FIG. 4

Initializing $M$ convolution kernels

500

Calculating $M$ derivatives for the $n^{th}$ block of $N$ discrete samples

510

Calculating at lest one value of the continuous signal in at least one location within a neighborhood defined by a predefined interval length and having an integral point in the $n^{th}$ block of $N$ discrete samples as a center point

520

Is the at least a portion of the continuous signal processed entirely?

530

Yes

End

No

Increment $n$

540

# FIG. 5

600

Signal Processing
Module
618

Processor
612

Memory
614

Processing Circuitry
610

Communication
Interface
616

FIG. 6

700

702

Receiving
Apparatus

706

Network

704

Signal Source
Apparatus

# FIG. 7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **T. MOELLER et al.** Evaluation and design of filters using a Taylor series expansion. *IEEE Transactions on Visualization and Computer Graphics,* 01 January 1997, vol. 3 (2), 184-199